# EUROPÄISCHE PATENTANMELDUNG

(11) **EP 2 626 710 A1**
(43) Veröffentlichungstag der Anmeldung: **14.08.2013**
(21) Anmeldenummer: 13000598.6
(22) Anmeldetag: 06.02.2013
(51) Int. Cl.: G01R 11/04, G01R 22/06

(54) **Zählertraggehäuse für einen Zählerschrank**

(30) Priorität: 10.02.2012 DE 102012002656
(71) Anmelder: ABB AG, 68309 Mannheim (DE)
(72) Erfinder: Christ, Peter, 12623 Berlin (DE)

(57) **Zusammenfassung**

Die Erfindung betrifft ein Zählertraggehäuse (1) für einen Zählerschrank zur Montage eines Stromzählers (2), wobei das Zählertraggehäuse (1) für jede Phase umfasst - ein erstes Anschlussmittel (3, 3', 3") zum Anschluss eines Zugangsleiters (4, 4', 4"), - ein zweites Anschlussmittel (5, 5', 5") zum Anschluss eines Abgangsleiters (6, 6', 6"), - ein erstes (7, 7', 7") und ein zweites (8, 8', 8") feststehendes Kontaktstück, mit denen am Zähler (2) befindliche erste und zweite Kontaktfahnen (9, 9', 9"; 10, 10', 10") bei dessen Montage in Eingriff bringbar sind. Das Zählertraggehäuse (1) umfasst für jede Phase einen Stromwandler (11, 11', 11") mit einem Primärkreis (12, 12', 12") und einem Sekundärkreis (13, 13', 13"), wobei der Primärkreis (12, 12', 12") in dem Strompfad zwischen dem ersten (3, 3', 3") und dem zweiten (5, 5', 5") Anschlussmittel angeordnet ist, wobei der Sekundärkreis (13, 13', 13") in dem Strompfad zwischen dem ersten (7, 7', 7") und dem zweiten (8, 8', 8") feststehenden Kontaktstück angeordnet ist.

## Beschreibung

Die Erfindung betrifft ein Zählertraggehäuse für einen Zählerschrank zur Montage eines elektronischen Stromzählers wobei das Zählertraggehäuse für jede Phase ein erstes Anschlussmittel zum Anschluss eines Zugangsleiters, ein zweites Anschlussmittel zum Anschluss eines Abgangsleiters, ein erstes und ein zweites feststehendes Kontaktstück, mit denen am elektronischen Stromzähler befindliche erste und zweite Kontaktfahnen bei dessen Montage in Eingriff bringbar sind, umfasst, gemäß dem Oberbegriff des Anspruchs 1.

Die Erfindung betrifft weiter einen Zählerschrank mit einem Zählerplatz zur Aufnahme wenigstens eines elektronischen Haushaltszählers, gemäß dem Oberbegriff des Anspruchs 9.

Ein solches gattungsgemäßes Zählertraggehäuse ist beispielsweise aus der DE 10 2004 022 783 B4 und ein gattungsgemäßer Zählerschrank mit einem Zählerplatz ist aus der DE 10 2004 022 785 A1 bekannt.

Mit einem Stromzähler wird bekanntermaßen eigentlich die Summe der einer Anzahl von Verbrauchern zugeführten elektrischen Energie gemessen und erfasst. Bekannt sind elektromechanische Energiezähler mit Ferraris-Zählwerken, und elektronische Stromzähler, beispielsweise ein elektronischer Haushaltszähler, auch eHZ für elektronischer Haushaltszähler genannt, der mit Kontaktfahnen an seiner Unterseite versehen ist. Ein elektromechanischer Energiezähler wird in dem Zählerplatz an einem Zählerkreuz montiert. Ein elektronischer Haushaltszähler kann zur Montage auf ein Zählertraggehäuse aufgesetzt werden, wobei innerhalb des Zählertraggehäuses Kontaktstücke vorgesehen sind, mit denen die Kontaktfahnen in elektrisch leitende Verbindung bringbar sind. Die Kontaktstücke sind dabei üblicherweise U-förmig ausgebildet und über an einem der Schenkel der U-Form angeschlossene Anschlussfahnen mit Zu- bzw. Abgangsleitern verbunden.

Zu Zählerplätzen für die Aufnahme von elektromechanischen Energiezählern und von eHZ gibt es eine Reihe von technischen Normen, beispielsweise die DIN VDE 0603-1, DIN V VDE V 0603-5, DIN V VDE V 0603-102, DIN43870-1 und A1, DIN43870-2 und A1, DIN43870-3 und A1. Elektronische Haushaltszähler eHZ sind dabei gemäß VDN-Lastenheft Elektronischer Haushaltszähler Version 1.02 bis zu einer maximalen Strombelastung von 60A definiert.

Zur Montage eines solchen eHZ bis 60A wird ein Zählertraggehäuse, eine sogenannte BKE, Befestigungs- und Kontaktiereinrichtung, welche bis zu einem Maximalstrom von 63A definiert ist, für einen eHZ benötigt.

Die Begriffe BKE und Zählertraggehäuse werden im Folgenden in synonymer Bedeutung verwendet.

Wenn der BKE in dem Zählerschrank der Installationsanlage fest eingebaut ist, bildet der BKE einen Teil des Zählerplatzes, er ist gewissermaßen in den Zählerplatz integriert und wird dann auch kurz als BKE-1 bezeichnet. Wenn die BKE nach Art eines Adapters auf das Zählerkreuz aufgesetzt wird, spricht man von einer BKE-A.

Beim Zählerwechsel überbrückt die BKE die Strombahn, so dass das Abziehen beziehungsweise Demontieren des Zählers nicht zur Energieunterbrechung führt. Dazu hat die BKE einen Kontaktapparat, der dazu eingerichtet ist, um bei einem Zählerwechsel die Strombahn zwischen den ersten und zweiten feststehenden Kontaktstücken zu überbrücken. Ein solcher Kontaktapparat ist beispielsweise in der DE 103 44 736 A1 beschrieben.

Das Zählertraggehäuse hat eine im wesentlichen quaderförmige Gestalt. In seiner oberen Breitseite sind Schlitze zur Aufnahme der Kontaktfahnen des Stromzählers vorhanden.

Ein BKE-1 hat an einer ersten Schmalseite des Gehäuses, die hier daher auch als Einführ-Schmalseite bezeichnet wird, Einführöffnungen für die Aufnahme von Zugangsleitern bei der Installation in dem Zählerschrank, auch als Anschlussleiter bezeichnet. An einer zweiten Schmalseite, die hier daher auch als Abgangs-Schmalseite bezeichnet wird, und die der Einführ-Schmalseite üblicherweise gegenüberliegt, hat ein BKE-1 Ausgangsöffnungen für die Aufnahme von Abgangsleitern bei der Installation in dem Zählerschrank. Der Stromzähler ist also mittels eines BKE-1 im Zählerschrank elektrisch zwischen den Zugangs- und den Abgangsleitern geschaltet. In dem Zählertraggehäuse befinden sich dazu erste und zweite Anschlussmittel zum Anschluss der Zugangs- bzw. Abgangsleiter.

Die bekannte BKE ist bisher ein Bauteil, welches die elektrische Energie über Kontaktteile direkt in den eHZ leitet. Sie wird daher auch als BKE für einen direkt messenden eHZ bezeichnet. Diese BKE ist wie oben dargelegt, ausgelegt für Ströme bis 63A. Der eHZ selbst ist für Ströme bis 60 A ausgelegt, weil in einem etwas abweichenden Stromgrößenraster für Zähler festgelegt. Bei höheren Strömen als 60A würde die Verlustleistung in den internen Leitungen und an den Kontaktstellen und in dem Kontaktapparat der bekannten BKE zu hoch werden, so dass diese nicht für Anwendungen bei Strömen größer als 60A verwendet werden kann.

Für Anwendungen mit Strömen über 60A wäre die Konstruktion eines eigens daran angepassten BKE-Gerätes mit veränderter Gestaltung der Kontakte und des Kontaktapparates nötig. Solche für höhere Stromstärken als 60A geeigneten Kontakte und Kontaktapparate allerdings sind für die Ströme bis zu 60A zu aufwändig und teuer.

Es ist vor diesem Hintergrund die Aufgabe der vorliegenden Erfindung, eine bekannte BKE mit einer Leiter- und Kontaktiervorrichtung, die bis maximal 60A ausgelegt ist, so weiterzubilden, dass mit ihr Messungen mit einem eHZ für Mess- und Wandlerbetrieb und mit Strömen über 60A durchgeführt und Ströme höher als 60A erfasst werden können.

Die Aufgabe wird gelöst durch ein Zählertraggehäuse mit den kennzeichnenden Merkmalen des Anspruchs 1.

Erfindungsgemäß also umfasst das Zählertraggehäuse für jede Phase einen Stromwandler mit einem Primärkreis und einem Sekundärkreis, wobei der Primärkreis in dem Strompfad zwischen dem ersten und dem zweiten Anschlussmittel angeordnet ist, wobei der Sekundärkreis in dem Strompfad zwischen dem ersten und dem zweiten feststehenden Kontaktstück angeordnet ist.

Der Vorteil eines erfindungsgemäß gestalteten Zählertraggehäuses liegt darin, dass dadurch, dass in der BKE ein Stromwandler eingebaut wird, der Strom in dem Strompfad zwischen dem Zugangs- und dem Abgangsleiter, welcher größer als 60A sein kann, durch den Primärkreis des Stromwandlers fließt, nicht aber über den Kontaktapparat der BKE. Über die Leiter- und Kontaktiervorrichtung und den Kontaktapparat der BKE und in den eHZ fließt nur der Sekundärstrom. Der Stromwandler kann so gestaltet sein, dass der Sekundärstrom auch bei dem höchsten im Betrieb zugelassenen Primärstrom immer kleiner ist als die 60A, für die die Leiter- und Kontaktiervorrichtung und der Kontaktapparat der BKE ausgelegt ist.

Der elektronische Stromzähler umfasst in einer besonders vorteilhaften Ausführungsform eine Funktion, mittels derer der erfasste Strommesswert mit dem Wandlerfaktor des Stromwandlers multipliziert wird, so dass der eHZ physikalisch zwar einen niedrigeren Strom misst, nämlich den Sekundärstrom im Sekundärstromkreis, jedoch denjenigen Strommesswert, der dem wahren Strom entspricht, zur Anzeige bringt und zur Ermittlung der elektrischen Energie heranzieht. Das Zählertraggehäuse kann dazu in einer vorteilhaften Ausführungsform eine Codiervorrichtung umfassen, in der der Wandlerfaktor der Stromwandler hinterlegt ist, und mittels derer der Wandlerfaktor bei der Montage dem eHZ automatisch übermittelt wird.

Auf diese Weise kann ein BKE mit der kostengünstigen Auslegung seiner leiter- und Kontaktiereinrichtung für Ströme kleiner als 60A auch für die Erfassung von Strömen über 60A verwendet werden.

Gemäß einer vorteilhaften Ausführungsform der Erfindung umfasst die erfindungsgemäße BKE einen Kontaktapparat, der dazu eingerichtet ist, um bei einem Zählerwechsel die Strombahn zwischen den ersten und zweiten feststehenden Kontaktstücken zu überbrücken. Dies kann in vorteilhafter Weise so gestaltet sein, dass der Kontaktapparat mit je einem Überbrückungselement für jede Phase versehen ist, wobei die Überbrückungselemente aller Phasen gemeinsam mit den jeweils zugehörigen feststehenden Kontaktstücken bei Ausbauen des Stromzählers zur Überbrückung in jeder Phase in elektrisch leitende Verbindung bringbar sind und umgekehrt, wobei die Bewegung der Überbrückungselemente so gesteuert ist, dass bei der Demontage zunächst die Überbrückungselemente in elektrisch leitende Verbindung mit den zugehörigen festen Kontaktstücken gelangen und erst dann die Kontaktfahnen des Stromzählers frei von den ersten und zweiten feststehenden Kontaktstücken kommen. Vorteilhaft ist, dass, wenn der eHZ, beispielsweise beim Zählerwechsel, abgezogen wird, automatisch der Sekundärkreis des Wandlers überbrückt wird, so dass dieser nicht überlastet werden kann.

Die erfindungsgemäße BKE ist in den Abmessungen so gehalten, dass sie in ein Zählerfeld nach den Standardabmessungen gemäß den oben erwähnten DIN-Normen eingesetzt oder auf dem Zählerkreuz montiert werden kann.

Gemäß einer vorteilhaften Ausführungsform der Erfindung kann eine zusätzliche Vorrichtung oder Kennzeichnung vorgesehen sein, mit der eine BKE mit Stromwandler von einer ansonsten nach außen gleich aussehenden BKE ohne Stromwandler unterschieden werden kann, um Verwechslungen zwischen einer BKE für einen direkt messenden eHZ und einer BKE mit Messwandler für einen Messwandler-eHZ zu vermeiden. Eine solche Kennzeichnungsvorrichtung kann beispielsweise ein Wechselschilderrahmen sein, in den ein austauschbares Schild eingesetzt werden kann, welches jeweils auf den Typ der vorliegenden BKE hinweist. Es könnte sich auch um eine elektronische Anzeige, etwa ein kleines LCD-Display, handeln, das dann auch gleich den aktuellen Wandlerfaktor anzeigt. Oder es könnte eine farbige Leuchtanzeige sein, etwa eine erste Farbe, beispielsweise blau, für einen BKE mit Stromwandler und eine zweite Farbe, beispielsweise weiß, für eine BKE ohne Stromwandler.

Ein erfindungsgemäßer Zählerschrank mit einem Zählerplatz zur Aufnahme wenigstens eines Haushaltszählers ist dadurch gekennzeichnet, dass an der Abdeckplatte des Zählerplatzes eine Aussparung zur Aufnahme eines Zählertraggehäuses wie oben beschrieben vorgesehen ist, also eines Zählertraggehäuses, das für jede Phase einen Stromwandler mit einem Primärkreis und einem Sekundärkreis umfasst, wobei der Primärkreis in dem Strompfad zwischen dem ersten und dem zweiten Anschlussmittel angeordnet ist, und wobei der Sekundärkreis in dem Strompfad zwischen dem ersten und dem zweiten feststehenden Kontaktstück angeordnet ist.

Weitere vorteilhafte Ausgestaltungen und Verbesserungen der Erfindung und weitere Vorteile sind den weiteren Unteransprüchen zu entnehmen.

Anhand der Zeichnung, in der ein Ausführungsbeispiel der Erfindung dargestellt ist, sollen die Erfindung sowie weitere vorteilhafte Ausgestaltungen und Verbesserungen der Erfindung näher erläutert und beschrieben werden.

Es zeigen:

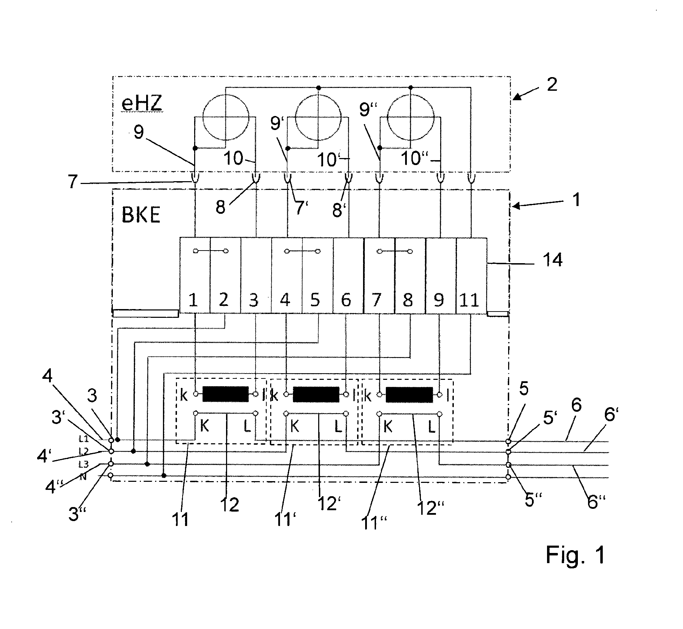

- Figur 1: eine schematische Darstellung des Stromlaufs eines erfindungsgemäßen dreiphasigen Zählertraggehäuses mit aufgesetztem eHZ.

Die Figur 1 zeigt schematisch ein Zählertraggehäuse 1, mit BKE bezeichnet, für einen Zählerschrank zur Montage eines dreiphasigen Stromzählers 2, mit eHZ bezeichnet.

Das Zählertraggehäuse 1 umfasst für jede der Phasen L1, L2, L3:
- ein erstes Anschlussmittel 3, 3', 3" zum Anschluss eines Zugangsleiters 4, 4', 4", beispielsweise eine Zugangsklemme in einem Zugangs-Klemmenaufnahmeraum,
- ein zweites Anschlussmittel 5, 5', 5" zum Anschluss eines Abgangsleiters 6, 6', 6", beispielsweise eine Abgangsklemme in einem Abgangs-Klemmenaufnahmeraum,
- ein erstes und ein zweites feststehendes Kontaktstück 7, 7', 7",8, 8', 8", mit denen am Zähler 2 befindliche erste und zweite Kontaktfahnen 9, 9', 9"; 10, 10', 10" bei dessen Montage in Eingriff bringbar sind.

In dem Zählertraggehäuse 1 befinden sich drei Stromwandler 11, 11', 11", für jede Phase einer. Die Stromwandler sind induktive Wandler. Jeder Stromwandler hat einen Primärkreis 12, 12', 12" und einen Sekundärkreis 13, 13', 13". Der Primärkreis 12, 12', 12" ist in dem Strompfad zwischen dem ersten und dem zweiten Anschlussmittel 3, 3', 3",5, 5', 5" angeordnet. Der Sekundärkreis 13, 13', 13" ist jeweils in dem Strompfad zwischen dem ersten und dem zweiten feststehenden Kontaktstück 7, 7', 7", 8, 8', 8" angeordnet.

In dem Strompfad zwischen dem Sekundärkreis und den feststehenden Kontaktfahnen befindet sich ein Kontaktapparat 14, der dazu eingerichtet ist, um bei einem Zählerwechsel die Strombahn zwischen den ersten und zweiten feststehenden Kontaktstücken 7, 7', 7", 8, 8', 8" zu überbrücken. Der Kontaktapparat ist dabei ähnlich ausgebildet wie in der DE 10344736 A1 bei einer direkt messenden BKE gezeigt. Auch andere Kontaktapparate können selbstverständlich verwendet werden, sofern sie die Funktion erfüllen, bei einem Zählerwechsel für ein Überbrücken der Sekundärkreise der Stromwandler zu sorgen.

Die vorliegende Erfindung umfasst neben dem beschriebenen Ausführungsbeispiel auch beliebige Kombinationen bevorzugter Ausführungsformen sowie einzelner Ausgestaltungsmerkmale oder Weiterbildungen, sofern diese sich nicht gegenseitig ausschließen.

### Bezugszeichenliste

- 1: Zählertraggehäuse
- 2: Stromzähler
- 3, 3', 3": erstes Anschlussmittel
- 4, 4', 4": Zugangsleiter
- 5, 5', 5": zweites Anschlussmittel
- 6, 6', 6": Abgangsleiter
- 7, 7', 7": erstes feststehendes Kontaktstück
- 8, 8', 8": zweites feststehendes Kontaktstück
- 9, 9', 9": Kontaktfahne
- 10, 10', 10": Kontaktfahne
- 11, 11', 11": Stromwandler
- 12, 12', 12": Primärkreis
- 13, 13', 13": Sekundärkreis
- 14: Kontaktapparat

## Patentansprüche

1. Zählertraggehäuse (1) für einen Zählerschrank zur Montage eines Stromzählers (2), wobei das Zählertraggehäuse (1) für jede Phase umfasst
- ein erstes Anschlussmittel (3, 3', 3") zum Anschluss eines Zugangsleiters (4, 4', 4"),
- ein zweites Anschlussmittel (5, 5', 5") zum Anschluss eines Abgangsleiters (6, 6', 6"),
- ein erstes (7, 7', 7") und ein zweites (8, 8', 8") feststehendes Kontaktstück, mit denen am Zähler (2) befindliche erste und zweite Kontaktfahnen (9, 9', 9"; 10, 10', 10") bei dessen Montage in Eingriff bringbar sind,
**dadurch gekennzeichnet, dass** das Zählertraggehäuse (1) für jede Phase einen Stromwandler (11, 11', 11") mit einem Primärkreis (12, 12', 12") und einem Sekundärkreis (13, 13', 13") umfasst, wobei der Primärkreis (12, 12', 12") in dem Strompfad zwischen dem ersten (3, 3', 3") und dem zweiten (5, 5', 5") Anschlussmittel angeordnet ist, wobei der Sekundärkreis (13, 13', 13") in dem Strompfad zwischen dem ersten (7, 7', 7") und dem zweiten (8, 8', 8") feststehenden Kontaktstück angeordnet ist.

2. Zählertraggehäuse (1) nach Anspruch 1, mit einem Kontaktapparat (14), der dazu eingerichtet ist, um bei einem Zählerwechsel die Strombahn zwischen den ersten (7, 7', 7") und zweiten (8, 8', 8") feststehenden Kontaktstücken zu überbrücken.

3. Zählertraggehäuse (1) nach Anspruch 2, wobei der Kontaktapparat (14) mit je einem Überbrückungselement für jede Phase versehen ist, wobei die Überbrückungselemente aller Phasen gemeinsam mit den jeweils zugehörigen feststehenden Kontaktstücken (7, 7', 7"; 8, 8', 8") bei Ausbauen des Stromzählers (2) zur Überbrückung in jeder Phase in elektrisch leitende Verbindung bringbar sind und umgekehrt, wobei die Bewegung der Überbrückungselemente so gesteuert ist, dass bei der Demontage zunächst die Überbrückungselemente in elektrisch leitende Verbindung mit den zugehörigen festen Kontaktstücken (7, 7', 7"; 8, 8', 8") gelangen und erst dann die Kontaktfahnen ((9, 9', 9"; 10, 10', 10") des Stromzählers (2) frei von den ersten (7, 7', 7") und zweiten (8, 8', 8") feststehenden Kontaktstücken kommen.

4. Zählertraggehäuse (1) nach Anspruch 1, wobei der Stromwandler (11, 11', 11") dazu ausgebildet ist, um primärseitige Ströme von mehr als 60A in sekundärseitige Ströme von weniger als 60A zu wandeln.

5. Zählertraggehäuse (1) nach Anspruch 1, wobei das Zählertraggehäuse (1) dazu ausgebildet ist, um in einen Zählerplatz eingesetzt zu werden.

6. Zählertraggehäuse (1) nach Anspruch 1, wobei das Zählertraggehäuse (1) dazu ausgebildet ist, um auf einem Zählerkreuz montiert zu werden.

7. Zählertraggehäuse (1) nach Anspruch 1, **dadurch gekennzeichnet, dass** das Zählertraggehäuse (1) eine Codiervorrichtung umfasst, in der der Wandlerfaktor der Stromwandler (11, 11', 11") hinterlegt ist, zur automatischen Übermittlung des Wandlerfaktors bei der Montage an den Stromzähler (2).

8. Zählertraggehäuse (1) nach Anspruch 1, **dadurch gekennzeichnet, dass** das Zählertraggehäuse (1) eine Kennzeichnungsvorrichtung umfasst zur Unterscheidung des Zählertraggehäuses mit Stromwandler von einem ansonsten nach außen gleich aussehenden Zählertraggehäuse ohne Stromwandler.

9. Zählerschrank mit einem Zählerplatz zur Aufnahme wenigstens eines Haushaltszählers (2), **dadurch gekennzeichnet, dass** an der Abdeckplatte des Zählerplatzes eine Aussparung zur Aufnahme eines Zählertraggehäuses (1) nach einem der Ansprüche 1 bis 5 vorgesehen ist.
